# EUROPEAN PATENT APPLICATION

(11) **EP 4 243 285 A1**
(43) Date of publication of application: **13.09.2023**
(21) Application number: 21888553.1
(22) Date of filing: 02.11.2021
(51) Int. Cl.: H03H 17/02

(54) **FILTERING METHOD, SERVER AND STORAGE MEDIUM**

(30) Priority: 04.11.2020 CN 202011219112
(71) Applicant: ZTE Corporation, Shenzhen, Guangdong 518057 (CN)
(72) Inventor: XU, Xiangyang, Shenzhen, Guangdong 518057 (CN); HE, Haitao, Shenzhen, Guangdong 518057 (CN)
(74) Representative: Boult Wade Tennant LLP
(86) International application number: PCT/CN2021/128223
(87) International publication number: WO 2022/095856

(57) **Abstract**

Embodiments of the present application relate to the technical field of signal processing, and disclose a filtering method, a server and a storage medium. In the embodiments of the present application, the amount of frequency shift of a FRM filter is determined according to a bandwidth of a target signal; frequency shift is performed on the FRM filter according to the amount of frequency shift; and the target signal is filtered by means of the FRM filter subjected to the frequency shift.

## Description

### CROSS REFERENCE

This application is based on and claims the benefit of priority from Chinese Patent Application No. 202011219112.8, the entire content of which is incorporated herein by reference.

### TECHNICAL FIELD

Embodiments of the present application relate to the field of signal processing, in particular to a filtering method, a server and a storage medium.

### BACKGROUND

A filter with lower order can be designed as a filter with higher performance by Frequency Response Masking (FRM) technology, and the implementation process is as follows: firstly a base filter with lower order is designed, a complementary filter complementary to the base filter in amplitude is obtained, then, zero interpolation is performed on coefficients of the base filter and the complementary filter respectively, to obtain two complementary narrow-transition-band periodic multi-band frequency responses, and a masking filter is used to perform masking on the narrow-transition-band periodic multi-band frequency responses respectively, i.e., available frequency bands of the two are added to obtain a filter with higher performance. However, coefficients of the filter designed by FRM technology are relatively low in flexibility, and for signals of different bandwidths, it is required to redesign the coefficients of the filter by means of the FRM technology and then filter different signals.

### SUMMARY

Embodiments of the present application provide a filtering method, comprising: determining the amount of frequency shift of an FRM filter according to a bandwidth of a target signal; performing frequency shift on the FRM filter according to the amount of frequency shift; and filtering the target signal by means of the FRM filter subjected to the frequency shift.

Embodiments of the present application further provide a server, comprising: at least one processor; and a memory in communication connection with the at least one processor; wherein, the memory stores instructions executable by the at least one processor, and the instructions, when executed by the at least one processor, enable the at least one processor to implement the above-mentioned filtering method.

Embodiments of the present application further provide a computer readable storage medium having stored thereon a computer program to be executed by a processor, the above-mentioned filtering method is implemented when the computer program is executed by the processor.

### BRIEF DESCRIPTION OF DRAWINGS

Fig. 1 is a flow chart of a filtering method according to a first embodiment of the application;
Fig. 2 is a schematic diagram of a signal output by the FRM filter according to the first embodiment of the application;
Fig.3 is a schematic diagram of a signal output by the FRM filter subjected to positive frequency shift according to the first embodiment of the application;
Fig.4 is a schematic diagram of a signal output by the FRM filter subjected to negative frequency shift according to the first embodiment of the application;
Fig.5 is a schematic diagram of trend of a signal according to the first embodiment of the application;
Fig. 6 is a flow chart of a filtering method according to a second embodiment of the application;
Fig. 7 is a flow chart of a filtering method according to a third embodiment of the application;
Fig. 8 is a structure diagram of a server according to a fourth embodiment of the application.

### DETAILED DESCRIPTION

In order to make the purposes, technical solutions and advantages of the embodiments of the application clearer, the embodiments of the application will be described in detail below in combination with drawings. However, those ordinary skilled in the art can understand that in each embodiment of the application, many technical details are proposed to enable the readers to better understand the application. However, even without these technical details and various changes and modifications based on the following embodiments, the technical solutions claimed in the application can be implemented. The following division of embodiments is for the convenience of description, and should not limit the specific implementation mode of the application. All the embodiments can be combined and referred to each other without contradiction.

The embodiments of the present application provide a filtering method, a server and a storage medium, which can meet the requirements of signals of any bandwidth and are relatively high in flexibility.

The filtering method, server and storage medium provided by the invention, comprise: determining the amount of frequency shift of an FRM filter according to a bandwidth of a target signal; performing frequency shift on the FRM filter according to the amount of frequency shift; and filtering the target signal by means of the FRM filter subjected to the frequency shift. With such method, the FRM filter meeting the requirements of the target signal can be obtained only by means of frequency shift instead of redesigning the coefficients of the FRM filter, and at least a near-end interference signal of the target signal can be filtered out by using the FRM filter subjected to the frequency shift for filtering, that is, the requirements of signals of any bandwidth can be met by using only one set of coefficients of a filter, and the flexibility is higher.

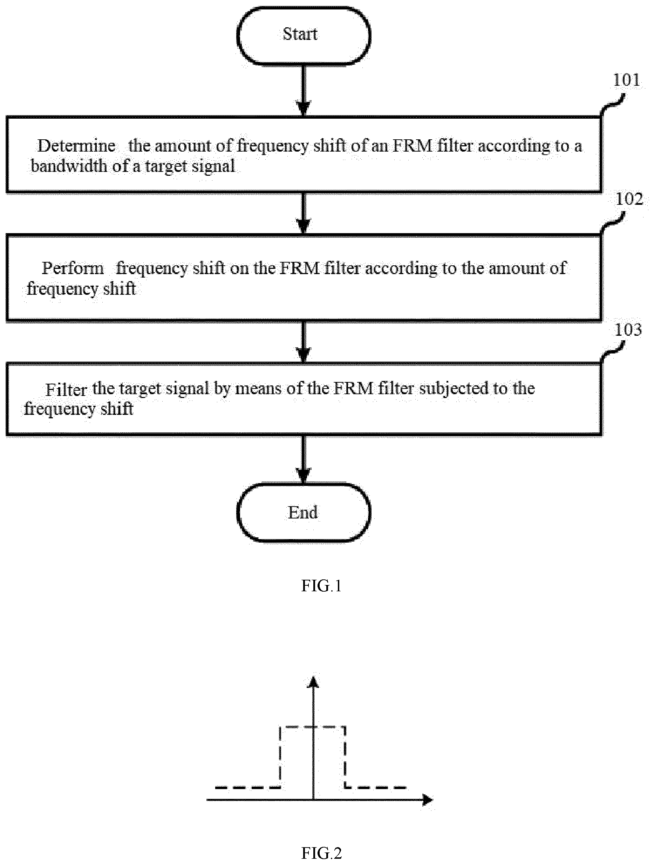

The first embodiment of the application relates to a filtering method, applied to an intermediate-frequency link configuration system, and the specific flow chart is shown in Fig. 1, comprising:
Step 101, determining the amount of frequency shift of a FRM filter according to a bandwidth of a target signal.

Specifically, the target signal may be a baseband signal generated by a system itself, or a signal received from external equipment. The system may perform frequency sweeping on the target signal through a frequency sweeper of the system itself to determine the bandwidth of the target signal, or, the system firstly sends the target signal to an external frequency sweeper of the system, and the external frequency sweeper performs frequency sweeping on the target signal to determine the bandwidth of the target signal, and sends the bandwidth of the target signal to the system. Since there may be an interference signal in the target signal, it is required to determine the amount of frequency shift according to the interference signal in the target signal to filter out the interference signal in the target signal, so that the stopband bandwidth of the FRM filter subjected to the frequency shift according to the amount of frequency shift is lower than or equivalent to the bandwidth of the interference signal, thus at least the near-end interference signal is filtered out, wherein, the stopband bandwidth of the FRM filter represents the bandwidth of the signal that can be filtered out by the FRM filter.

In one example, the determining the amount of frequency shift of an FRM filter according to a bandwidth of a target signal, comprises: determining the amount of frequency shift, corresponding to a bandwidth of a target signal, of an FRM filter according to preset correspondence between a bandwidth of the signal and the amount of frequency shift. Specifically, the position where the interference signal may exist in the signal can be predicted according to the bandwidth of the signal, so the amount, to which the stopband bandwidth of the FRM filter needs to be adjusted so as to filter out the possible interference signal, can be determined, thus, the amount of frequency shift of the FRM filter can be determined, therefore the correspondence between the bandwidth of the signal and the amount of frequency shift is directly established, and preset in the system locally, so that after determining the bandwidth of the target signal, the system can determine the amount of frequency shift corresponding to the bandwidth of the target signal according to the preset correspondence, and the determined amount of frequency shift is the amount of frequency shift of the FRM filter. The amount of frequency shift can be determined quickly by means of the preset correspondence between the bandwidth of the signal and the amount of frequency shift.

In one example, the determining the amount of frequency shift of an FRM filter according to a bandwidth of a target signal, comprises: comparing a bandwidth of a target signal with a preset bandwidth, and determining a bandwidth of an interference signal in the target signal; and determining the amount of frequency shift, corresponding to the bandwidth of the interference signal in target signal, of the FRM filter according to preset correspondence between the bandwidth of the interference signal and the amount of frequency shift. Specifically, the amount, to which the stopband bandwidth of the FRM filter needs to be adjusted so as to filter out the interference signal, can be determined according to the bandwidth of the interference signal, thus the amount of frequency shift of the FRM filter can be determined, therefore the correspondence between the bandwidth of the interference signal and the amount of frequency shift can be directly established, and preset in the system locally, so that after determining the bandwidth of the target signal, the system can compare the bandwidth of the target signal with the preset bandwidth, the preset bandwidth refers to the operating bandwidth of the system or the preset bandwidth can be set according to actual needs, the bandwidth, not falling into the preset bandwidth, of the target signal is the bandwidth of the interference signal in the target signal, then, the amount of frequency shift corresponding to the bandwidth of the interference signal in the target signal can be determined according to the preset correspondence, and the determined amount of frequency shift is the amount of frequency shift of the FRM filter. With such method, the bandwidth of the interference signal in target signal can be determined in real time according to the bandwidth of the target signal at present, so that the determined bandwidth of the interference signal is more accurate, then the amount of frequency shift of the FRM filter is determined according to the preset correspondence between the bandwidth of the interference signal and the amount of frequency shift, so that the amount of frequency shift of the FRM filter can be determined quickly and accurately.

Step 102, performing frequency shift on the FRM filter according to the amount of frequency shift.

Step 103, filtering the target signal by means of the FRM filter subjected to the frequency shift.

In one example, a Numerically Controlled Oscillator (NCO) in the system performs frequency shift on the FRM filter according to the amount of frequency shift, namely the NCO performs point multiplication on a coefficient of the FRM filter and a corresponding coefficient in the amount of frequency shift, an obtained result serves as a new coefficient of the FRM filter, therefore frequency shift on the FRM filter is implemented. Due to use of the point multiplication manner, neither the amount of non-zero coefficients in the coefficients of the FRM filter nor the order of the FRM filter is changed. After that the FRM filter subjected to the frequency shift is obtained, the system inputs the target signal into the FRM filter subjected to the frequency shift, the FRM filter subjected to the frequency shift at least filters out the near-end interference signal in the target signal, and obtains a filtered target signal.

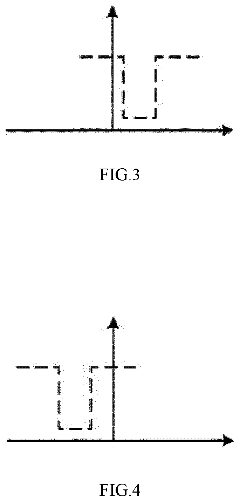

In one example, the system firstly determines the amount of frequency shift of the FRM filter according to the bandwidth of the target signal, if the amount of frequency shift comprises a positive amount of frequency shift, it indicates that the target signal includes a left-end interference signal, at this time positive frequency shift is performed on the FRM filter according to the positive amount of frequency shift, namely, the frequency point of the FRM filter moves towards the end with higher frequency, the FRM filter subjected to positive frequency shift filters the target signal to obtain the filtered target signal, Fig. 2 shows a schematic diagram of the signal output by the FRM filter, Fig.3 shows a schematic diagram of the signal output by the FRM filter subjected to positive frequency shift, and with such method at least the left near-end interference signal of target signal can be filtered out.

In one example, the system firstly determines the amount of frequency shift of the FRM filter according to the bandwidth of the target signal, if the amount of frequency shift comprises a negative amount of frequency shift, it indicates that the target signal includes a right-end interference signal, at this time negative frequency shift is performed on the FRM filter according to the negative amount of frequency shift, namely, the frequency point of the FRM filter moves towards the end with lower frequency, the FRM filter subjected to negative frequency shift filters the target signal to obtain the filtered target signal, Fig.4 shows a schematic diagram of the signal output by the FRM filter subjected to negative frequency shift, and with such method at least the right near-end interference signal of target signal can be filtered out.

In one example, the amount of frequency shift comprises positive amount of frequency shift and negative amount of frequency shift, and the performing frequency shift on the FRM filter according to the amount of frequency shift, comprises: performing positive frequency shift on the FRM filter according to the positive amount of frequency shift to obtain a FRM filter subjected to the positive frequency shift, and performing negative frequency shift on the FRM filter according to the negative amount of frequency shift to obtain a filter subjected to the negative frequency shift; the filtering the target signal by means of the FRM filter subjected to the frequency shift, comprises: filtering the target signal by means of the FRM filter subjected to the positive frequency shift to obtain an intermediate signal, and filtering the intermediate signal by means of the filter subjected to the negative frequency shift. Specifically, the system firstly determines the amount of frequency shift of the FRM filter according to the bandwidth of the target signal, if the amount of frequency shift comprises the positive amount of frequency shift and the negative amount of frequency shift, it indicates that at this time the target signal comprises the left-end interference signal and the right-end interference signal, and at this time the NCO in the system performs the positive frequency shift on the FRM filter according to the positive amount of frequency shift to obtain the FRM filter subjected to the positive frequency shift, and performs the negative frequency shift on the FRM filter according to the negative amount of frequency shift to obtain the FRM filter subjected to the negative frequency shift. Hereafter, the system filters the target signal by means of the FRM filter subjected to the positive frequency shift to obtain the intermediate signal, at this time at least the left near-end interference signal in the target signal can be filtered out, then, the intermediate signal is filtered by means of the FRM filter subjected to the negative frequency shift, at this time at least the right near-end interference signal in the intermediate signal can be filtered out, and therefore at least the left near-end interference signal and the right near-end interference signal of the target signal both can be filtered out.

In one example, the amount of frequency shift comprises positive amount of frequency shift and negative amount of frequency shift, and the performing frequency shift on the FRM filter according to the amount of frequency shift, comprises: performing positive frequency shift on the FRM filter according to the positive amount of frequency shift to obtain a FRM filter subjected to the positive frequency shift, and performing negative frequency shift on the FRM filter according to the negative amount of frequency shift to obtain a filter subjected to the negative frequency shift; the filtering the target signal by means of the FRM filter subjected to the frequency shift, comprises: filtering the target signal by means of the FRM filter subjected to the negative frequency shift to obtain an intermediate signal, and filtering the intermediate signal by means of the filter subjected to the positive frequency shift. Specifically, the system firstly determines the amount of frequency shift of the FRM filter according to the bandwidth of the target signal, if the amount of frequency shift comprises the positive amount of frequency shift and the negative amount of frequency shift, it indicates that at this time the target signal comprises the left-end interference signal and the right-end interference signal, and at this time the NCO in the system performs the positive frequency shift on the FRM filter according to the positive amount of frequency shift to obtain the FRM filter subjected to the positive frequency shift, and performs the negative frequency shift on the FRM filter according to the negative amount of frequency shift to obtain the FRM filter subjected to the negative frequency shift. Hereafter, the system filters the target signal by means of the FRM filter subjected to the negative frequency shift to obtain the intermediate signal, at this time at least the right near-end interference signal in the target signal can be filtered out, then, the intermediate signal is filtered by means of the FRM filter subjected to the positive frequency shift, at this time at least the left near-end interference signal in the intermediate signal can be filtered out, and therefore at least the left near-end interference signal and the right near-end interference signal of the target signal can be both filtered out.

In one example, the FRM filter comprises an interpolated base filter, an interpolated complementary filter and a masking filter, wherein, a base filter and the masking filter are designed in the system in advance, the interpolated base filter can be obtained by interpolating zero into the base filter, the higher the interpolating multiple is, the steeper a transition band is, the interpolating multiple can be set according to actual needs, and is not specifically defined in the embodiment, the base filter can be any filter designed in advance, such as: the base filter can be a half-band filter and etc.; then, the interpolated complementary filter whose interpolating multiple is the same with that of the interpolated base filter is obtained according to the interpolated base filter, and therefore, the FRM filter comprising the interpolated base filter, the interpolated complementary filter and the masking filter can be obtained. In one example, when the system obtains target signal, the amount of frequency shift is determined according to the bandwidth of target signal, if the amount of frequency shift comprises the positive amount of frequency shift, at this time the NCO in the system performs positive frequency shift on the interpolated complementary filter according to a frequency shift coefficient for the interpolated complementary filter in the positive amount of frequency shift to obtain the interpolated complementary filter subjected to the positive frequency shift, and performs positive frequency shift on the masking filter according to a frequency shift coefficient for the masking filter in the positive amount of frequency shift to obtain the masking filter subjected to the positive frequency shift. Hereafter the system divides the target signal into two paths, one path of target signal firstly passes the interpolated base filter subjected to the positive frequency shift, then passes the masking filter subjected to the positive frequency shift, to obtain a first intermediate signal, the other path of target signal passes the interpolated complementary filter subjected to the positive frequency shift, to obtain a second intermediate signal, the time domain of the first intermediate signal is added to that of the second intermediate signal, to obtain the filtered target signal, and at this time at least the left near-end interference signal of the target signal can be filtered out. Or, the target signal is divided into two paths, one path of target signal firstly passes the interpolated complementary filter subjected to the positive frequency shift, then passes the masking filter subjected to the positive frequency shift, to obtain the first intermediate signal, the other path of target signal passes the interpolated base filter subjected to the positive frequency shift, to obtain the second intermediate signal, the time domain of the first intermediate signal is added to that of the second intermediate signal, to obtain the filtered target signal, and at this time at least the left near-end interference signal of the target signal can be filtered out.

In one example, when the system obtains a target signal, the amount of frequency shift is determined according to the bandwidth of the target signal, if the amount of frequency shift comprises the negative amount of frequency shift, at this time the NCO in the system performs negative frequency shift on the interpolated complementary filter according to the frequency shift coefficient for the interpolated complementary filter in the negative amount of frequency shift to obtain the interpolated complementary filter subjected to the negative frequency shift, and performs negative frequency shift on the masking filter according to the frequency shift coefficient for the masking filter in the negative amount of frequency shift to obtain the masking filter subjected to the negative frequency shift; the target signal is divided into two paths, one path of target signal firstly passes the interpolated base filter subjected to the negative frequency shift, and then passes the masking filter subjected to the negative frequency shift, to obtain the first intermediate signal, the other path of target signal passes the interpolated complementary filter subjected to the negative frequency shift, to obtain the second intermediate signal, the time domain of the first intermediate signal is added to that of the second intermediate signal, to obtain the filtered target signal, and at this time at least the right near-end interference signal of the target signal can be filtered out; or; the target signal is divided into two paths, one path of target signal firstly passes the interpolated complementary filter subjected to the negative frequency shift, and then passes the masking filter subjected to the negative frequency shift, to obtain the first intermediate signal, the other path of target signal passes the interpolated base filter subjected to the negative frequency shift, to obtain the second intermediate signal, the time domain of the first intermediate signal is added to that of the second intermediate signal, to obtain the filtered target signal, and at this time at least the right near-end interference signal of the target signal can be filtered out.

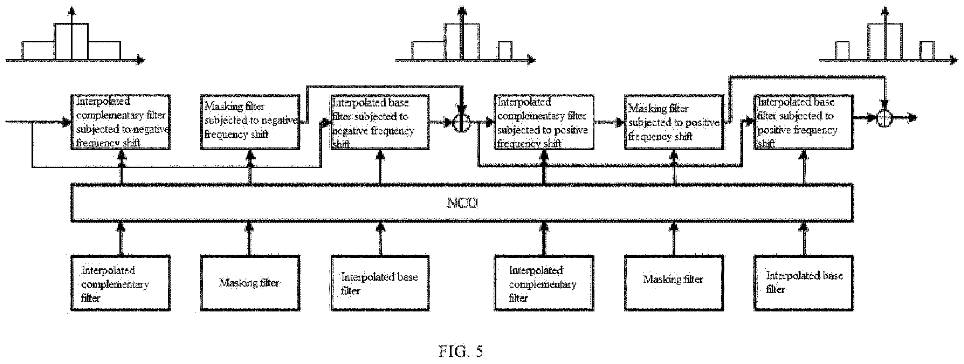

In one example, when the system obtains a target signal, the amount of frequency shift is determined according to the bandwidth of the target signal, if the amount of frequency shift comprises the positive amount of frequency shift and the negative amount of frequency shift, at this time the NCO in the system performs positive frequency shift on the interpolated base filter according to the frequency shift coefficient for the interpolated base filter in the positive amount of frequency shift to obtain the interpolated base filter subjected to the positive frequency shift, performs positive frequency shift on the interpolated complementary filter according to the frequency shift coefficient for the interpolated complementary filter in the positive amount of frequency shift to obtain the interpolated complementary filter subjected to the positive frequency shift, performs positive frequency shift on the masking filter according to the frequency shift coefficient for the masking filter in the positive amount of frequency shift to obtain the masking filter subjected to the positive frequency shift, and performs negative frequency shift on the interpolated base filter according to the frequency shift coefficient for the interpolated base filter in the negative amount of frequency shift to obtain the interpolated base filter subjected to the negative frequency shift, performs negative frequency shift on the interpolated complementary filter according to the frequency shift coefficient for the interpolated complementary filter in the negative amount of frequency shift to obtain the interpolated complementary filter subjected to the negative frequency shift, and performs negative frequency shift on the masking filter according to the frequency shift coefficient for the masking filter in the negative amount of frequency shift to obtain the masking filter subjected to the negative frequency shift. Hereafter the system filters the target signal by means of the FRM filter subjected to the frequency shift, Fig. 5 shows the schematic diagram of trend of the signal, the target signal is divided into two paths, one path of target signal firstly passes the interpolated complementary filter subjected to the negative frequency shift, then passes the masking filter subjected to the negative frequency shift, to obtain the first intermediate signal, the other path of target signal passes the interpolated base filter subjected to the negative frequency shift, to obtain the second intermediate signal, the time domain of the first intermediate signal is added to that of the second intermediate signal, to obtain the target signal subjected to negative filtering, and at this time at least the right near-end interference signal of the target signal can be filtered out; then the target signal subjected to negative filtering is divided into two paths, one path of target signal subjected to negative filtering firstly passes the interpolated complementary filter subjected to the positive frequency shift, and then passes the masking filter subjected to the positive frequency shift, to obtain a third intermediate signal, the other path of target signal subjected to negative filtering passes the interpolated base filter subjected to the positive frequency shift, to obtain a fourth intermediate signal, the time domain of the third intermediate signal is added to that of the fourth intermediate signal, to obtain the filtered target signal, at this time at least the left near-end interference signal of the target signal can be filtered out, and therefore at least the left near-end interference signal and the right near-end interference signal of the target signal can be both filtered out. Or, the target signal is divided into two paths, one path of target signal firstly passes the interpolated base filter subjected to the negative frequency shift, then passes the masking filter subjected to the negative frequency shift, to obtain the first intermediate signal, the other path of target signal passes the interpolated complementary filter subjected to the negative frequency shift, to obtain the second intermediate signal, the time domain of the first intermediate signal is added to that of the second intermediate signal, to obtain the target signal subjected to negative filtering, and at this time at least the right near-end interference signal of the target signal can be filtered out; then the target signal subjected to negative filtering is divided into two paths, one path of target signal subjected to negative filtering firstly passes the interpolated base filter subjected to the positive frequency shift, and then passes the masking filter subjected to the positive frequency shift, to obtain the third intermediate signal, the other path of target signal subjected to negative filtering passes the interpolated complementary filter subjected to the positive frequency shift, to obtain the fourth intermediate signal, the time domain of the third intermediate signal is added to that of the fourth intermediate signal, to obtain the filtered target signal, at this time at least the left near-end interference signal of the target signal can be filtered out, and therefore at least the left near-end interference signal and the right near-end interference signal of the target signal can be both filtered out. Or, the target signal is divided into two paths, one path of target signal firstly passes the interpolated complementary filter subjected to the positive frequency shift, then passes the masking filter subjected to the positive frequency shift, to obtain the first intermediate signal, the other path of target signal passes the interpolated base filter subjected to the positive frequency shift, to obtain the second intermediate signal, the time domain of the first intermediate signal is added to that of the second intermediate signal, to obtain the target signal subjected to positive filtering, and at this time at least the left near-end interference signal of the target signal can be filtered out; then the target signal subjected to positive filtering is divided into two paths, one path of target signal subjected to positive filtering firstly passes the interpolated complementary filter subjected to the negative frequency shift, and then passes the masking filter subjected to the negative frequency shift, to obtain the third intermediate signal, the other path of target signal subjected to positive filtering passes the interpolated base filter subjected to the negative frequency shift, to obtain the fourth intermediate signal, the time domain of the third intermediate signal is added to that of the fourth intermediate signal, to obtain the filtered target signal, at this time at least the right near-end interference signal of the target signal can be filtered out, and therefore at least the left near-end interference signal and the right near-end interference signal of the target signal can be both filtered out. Or, the target signal is divided into two paths, one path of target signal firstly passes the interpolated base filter subjected to the positive frequency shift, then passes the masking filter subjected to the positive frequency shift, to obtain the first intermediate signal, the other path of target signal passes the interpolated complementary filter subjected to the positive frequency shift, to obtain the second intermediate signal, the time domain of the first intermediate signal is added to that of the second intermediate signal, to obtain the target signal subjected to positive filtering, and at this time at least the left near-end interference signal of the target signal can be filtered out; then the target signal subjected to positive filtering is divided into two paths, one path of target signal subjected to positive filtering firstly passes the interpolated base filter subjected to the negative frequency shift, and then passes the masking filter subjected to the negative frequency shift, to obtain the third intermediate signal, the other path of target signal subjected to positive filtering passes the interpolated complementary filter subjected to the negative frequency shift, to obtain the fourth intermediate signal, the time domain of the third intermediate signal is added to that of the fourth intermediate signal, to obtain the filtered target signal, at this time at least the right near-end interference signal of the target signal can be filtered out, and therefore at least the left near-end interference signal and the right near-end interference signal of the target signal can be both filtered out.

In this embodiment, the system determines the amount of frequency shift of the FRM filter according to the bandwidth of the target signal; performs frequency shift on the FRM filter according to the amount of frequency shift; and filters the target signal by means of the FRM filter subjected to the frequency shift. With such method, the FRM filter meeting the requirements of the target signal can be obtained only by means of frequency shift instead of redesigning the coefficients of the FRM filter, and at least the near-end interference signal of the target signal can be filtered out by using the FRM filter subjected to the frequency shift for filtering, that is, the requirements of signals of any bandwidth can be met by using only one set of coefficients of a filter, and the flexibility is higher.

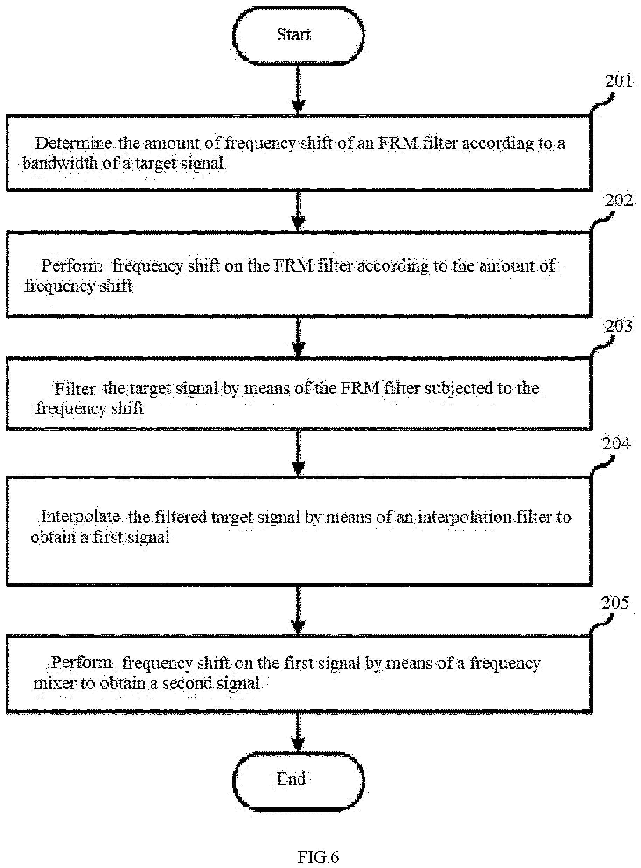

The second embodiment of the application relates to a filtering method, the second embodiment is approximately the same with the first embodiment, with the main difference that: the target signal is a locally generated baseband signal, a second signal satisfying the required frequency band of the system is obtained by means of an interpolation filter and a frequency mixer, and the specific flow chart is shown in Fig. 6, comprising:
Step 201, determining the amount of frequency shift of a FRM filter according to a bandwidth of a target signal.
Step 202, performing frequency shift on the FRM filter according to the amount of frequency shift.
Step 203, filtering the target signal by means of the FRM filter subjected to the frequency shift.

The steps 201-203 are similar to the steps 101-103 in the first embodiment, and will not be repeated here.

Step 204, interpolating the filtered target signal by means of an interpolation filter to obtain a first signal; wherein, an interpolation multiple in the interpolating is determined according to a baseband sampling rate and an intermediate frequency sampling rate.

Specifically, the target signal is the locally generated baseband signal, the sampling rate of the target signal is the baseband sampling rate, since the system needs to emit the signal to external equipment, and the digital signal emitted from the system needs to be converted into an analog signal by means of a digital to analog converter, that is the required sampling rate of the first signal emitted from the system equals the sampling rate of the digital to analog converter, i.e., the intermediate frequency sampling rate, therefore, the signal sampling rate needs to be changed to the intermediate frequency sampling rate by means of the interpolation filter, the interpolation multiple is the ratio of the intermediate frequency sampling rate to the baseband sampling rate, and the filtered target signal is interpolated by the interpolation filter to obtain the first signal. For example, if the baseband sampling rate is 122.88MSPS, and the intermediate frequency sampling rate is 368.64MSPS, the interpolation multiple is 368.64MSPS/122.88MSPS=3, the filtered target signal is interpolated by the interpolation filter to obtain the first signal at the sampling rate of 368.64MSPS.

In one example, before the interpolating the filtered target signal by means of the interpolation filter to obtain a first signal, the method further comprises: configuring a coefficient of the interpolation filter according to a bandwidth of an interference signal in the filtered target signal. Specifically, the coefficient of the interpolation filter is configurable, and can be modified in the manner of writing software in a random access memory, the system pre-stores the correspondence between the bandwidth of the signal and the coefficient of the interpolation filter, therefore the coefficient of the interpolation filter can be configured according to the bandwidth of the interference signal in the filtered target signal, in this way when the filtered target signal passes the interpolation filter, a far-end interference signal in the filtered target signal can be filtered out. With such method, while the sampling rate of the filtered target signal is changed, the far-end interference signal in the filtered target signal can be filtered out.

Step 205, performing frequency shift on the first signal by means of the frequency mixer to obtain the second signal.

Specifically, the system can preset the correspondence between the bandwidth of the signal and the amount of frequency shift in the frequency mixer, and performs frequency shift on the first signal according to the amount of frequency shift to obtain the second signal, or, the system can calculate the amount of frequency shift in real time by comparing the bandwidth of the first signal with the preset bandwidth, and performs frequency shift on the first signal according to the amount of frequency shift to obtain the second signal.

In this embodiment, after the filtered target signal is obtained, the filtered target signal is interpolated by the interpolation filter to obtain the first signal, the frequency mixer performs frequency shift on the first signal to obtain the second signal, and therefore the second signal satisfying the frequency band when the system emits the signal can be obtained.

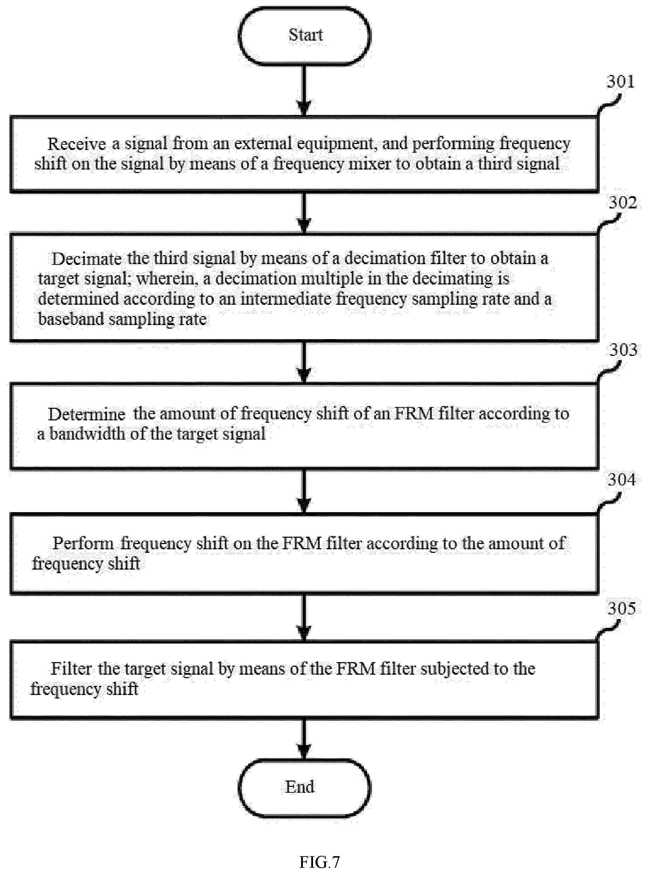

The third embodiment of the application relates to a parameter adjustment method, the third embodiment is approximately the same with the first embodiment, with the main difference that: a signal is received from an external equipment, and a target signal satisfying the required frequency band of the system is obtained by means of a frequency mixer and a decimation filter, and the specific flow chart is shown in Fig. 7, comprising:
Step 301, receiving a signal from an external equipment, and performing frequency shift on the signal by means of a frequency mixer to obtain a third signal.

Specifically, the system can preset the correspondence between the bandwidth of the signal and the amount of frequency shift in the frequency mixer, the frequency mixer determines the amount of frequency shift corresponding to the bandwidth of the received signal according to the correspondence, and frequency shift is performed on the received signal according to the amount of frequency shift to obtain the third signal, or, the system can calculate the amount of frequency shift in real time by comparing the bandwidth of the received signal with the preset bandwidth, and performs frequency shift on the received signal according to the amount of frequency shift to obtain the third signal.

Step 302, decimating the third signal by means of a decimation filter to obtain a target signal; wherein a decimation multiple in the decimating is determined according to an intermediate frequency sampling rate and a baseband sampling rate.

Specifically, the system receives the signal from the external equipment, and the received signal, which is an analog signal, needs to be converted into a digital signal via an analog to digital converter, namely, the sampling rate of the third signal is the sampling rate of the analog to digital converter, i.e., the intermediate frequency sampling rate, and the required sampling rate of the target signal is the baseband sampling rate, therefore, the signal sampling rate needs to be changed into the baseband sampling rate by means of the decimation filter, the decimation multiple is the ratio of the intermediate frequency sampling rate to the baseband sampling rate, and the third signal is decimated by the decimation filter to obtain the target signal. For example: if the baseband sampling rate is 122.88MSPS, and the intermediate frequency sampling rate is 368.64MSPS, the decimation multiple is 368.64MSPS/122.88MSPS=3, and the decimation filter performs decimating on the third signal to obtain the target signal at the sampling rate of 122.88MSPS.

In one example, before the decimating the third signal by means of the decimation filter to obtain a target signal, the method further comprises: configuring a coefficient of an interpolation filter according to a bandwidth of an interference signal in the third signal. Specifically, the coefficient of the decimation filter is configurable, and can be modified in the manner of writing software in the random access memory, the system pre-stores the correspondence between the bandwidth of the signal and the coefficient of the decimation filter, therefore the coefficient of the decimation filter can be configured according to the bandwidth of the interference signal in the third signal, in this way when the third signal passes the interpolation filter, a far-end interference signal in the third signal can be filtered out. Via such method, while the sampling rate of the third signal is changed, the far-end out-of-band interference signal in the third signal can be filtered out.

Step 303, determining the amount of frequency shift of a FRM filter according to a bandwidth of the target signal.

Step 304, performing frequency shift on the FRM filter according to the amount of frequency shift.

Step 305, filtering the target signal by means of the FRM filter subjected to the frequency shift.

The steps 303-305 are similar to the steps 101-103 in the first embodiment, and will not be repeated here.

In this embodiment, after the signal is received from the external equipment, the frequency mixer performs frequency shift on the signal to obtain the third signal, the decimation filter performs decimating on the third signal to obtain the target signal, and therefore the target signal satisfying the required frequency band of the system can be obtained.

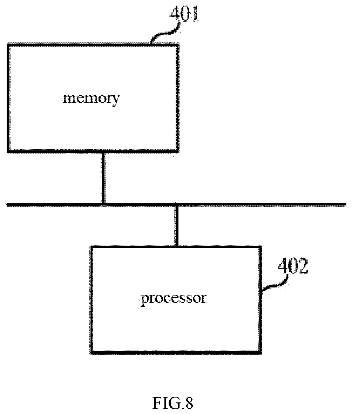

The fourth embodiment of the application relates to a server, as shown in Fig. 8, comprising at least one processor 402; and, a memory 401 in communication connection with the at least one processor; wherein, the memory 401 stores instructions executable by the at least one processor 402, and the instructions, when executed by the at least one processor 402, enable the at least one processor 402 to implement the embodiments of the above mentioned filtering method.

Wherein, the memory 401 and the processor 402 are connected by a bus, a bus may comprise a random number of interconnected buses and bridges, and various circuits of the one or more processor 402 and memory 401 are connected through the bus. Various other circuits such as periphery equipment, a voltage stabilizer and a power management circuit can be also connected together through the bus, which are well known in the art, and therefore, will not be further described herein. A bus interface provides an interface between the bus and a transceiver. The transceiver may be one component, or multiple components, such as a plurality of receivers and transmitters, which serves as a unit for communication with other apparatuses in the transmission media. Data processed by the processor 402 is transmitted in a wireless medium through an antenna, further, the antenna also receives data and transmits the data to the processor 402.

The processor 402 is responsible for bus management and common processing, and can provide various functions including timing, periphery interface, voltage regulation, power source management and other control functions. And the memory 401 can be used to store the data used by the processor 402 during execution.

The fifth embodiment of the application relates to a computer readable medium having stored thereon a computer program to be executed by a processor. The embodiments of the above method are implemented when the computer program is executed by the processor.

Namely, those skilled in the art can understand that all or part of the steps of the methods in the embodiments can be completed by instructing the relevant hardware through the program, and the program is stored in the storage medium, and comprises multiple instructions through which a device (such as a single-chip microcomputer, chip, and the like) or a processor can execute all or part of the steps of the methods in the embodiments. And the storage medium comprises: USB flash disk, mobile hard disk, read only memory (ROM), random access memory (RAM), magnetic disc or optical disc and other media that can store program codes.

Those ordinary skilled in the art can understand that the above embodiments are specific embodiments of the application, and in practical applications, they can be changed in form and detail without departing from the spirit and scope of the application.

## Claims

1. A filtering method, comprising:
determining the amount of frequency shift of a FRM filter according to a bandwidth of a target signal;
performing frequency shift on the FRM filter according to the amount of frequency shift;
filtering the target signal by means of the FRM filter subjected to the frequency shift.

2. The filtering method according to claim 1, wherein, the determining the amount of frequency shift of an FRM filter according to a bandwidth of a target signal, comprises:
determining the amount of frequency shift corresponding to a bandwidth of a target signal as the amount of frequency shift of a FRM filter according to preset correspondence between a bandwidth of the signal and the amount of frequency shift;
or;
comparing a bandwidth of a target signal with a preset bandwidth, and determining a bandwidth not falling into the preset bandwidth of the target signal as a bandwidth of an interference signal in the target signal;
determining the amount of frequency shift corresponding to the bandwidth of the interference signal in the target signal as the amount of frequency shift of the FRM filter according to preset correspondence between the bandwidth of the interference signal and the amount of frequency shift.

3. The filtering method according to claim 1 or 2, wherein, the performing frequency shift on the FRM filter according to the amount of frequency shift, comprises:
performing point multiplication on a coefficient of the FRM filter and a corresponding coefficient in the amount of frequency shift respectively, and taking an obtained result as a corresponding coefficient of the FRM filter subjected to the frequency shift.

4. The filtering method according to any one of claim 1 to 3, wherein, the amount of frequency shift comprises positive amount of frequency shift and negative amount of frequency shift, and the performing frequency shift on the FRM filter according to the amount of frequency shift, comprises:
performing positive frequency shift on the FRM filter according to the positive amount of frequency shift to obtain a FRM filter subjected to the positive frequency shift, and performing negative frequency shift on the FRM filter according to the negative amount of frequency shift to obtain a filter subjected to the negative frequency shift;
the filtering the target signal by means of the FRM filter subjected to the frequency shift, comprises:
filtering the target signal by means of the FRM filter subjected to the positive frequency shift to obtain an intermediate signal, and filtering the intermediate signal by means of the filter subjected to the negative frequency shift; or; filtering the target signal by means of the FRM filter subjected to the negative frequency shift to obtain an intermediate signal, and filtering the intermediate signal by means of the filter subjected to the positive frequency shift.

5. The filtering method according to any one of claim 1 to 4, wherein, the target signal is a locally generated baseband signal, and after the filtering the target signal by means of the FRM filter subjected to the frequency shift, the method further comprises:
interpolating the filtered target signal by means of an interpolation filter to obtain a first signal; wherein, an interpolation multiple in the interpolating is determined according to a baseband sampling rate and an intermediate frequency sampling rate;
performing frequency shift on the first signal by a frequency mixer to obtain a second signal.

6. The filtering method according to claim 5, wherein, before the interpolating the filtered target signal by means of an interpolation filter to obtain a first signal, the method further comprises:
configuring a coefficient of the interpolation filter according to a bandwidth of an interference signal in the filtered target signal.

7. The filtering method according to any one of claim 1 to 6, wherein, before the determining the bandwidth of the target signal, the method further comprises:
receiving a signal from an external equipment, and performing frequency shift on the signal by means of a frequency mixer to obtain a third signal;
decimating the third signal by means of a decimation filter to obtain a target signal; wherein a decimation multiple in the decimating is determined according to an intermediate frequency sampling rate and a baseband sampling rate.

8. The filtering method according to claim 7, wherein, before the decimating the third signal by means of a decimation filter to obtain a target signal, the method further comprises:
configuring a coefficient of an interpolation filter according to a bandwidth of an interference signal in the third signal.

9. A server, comprising:
at least one processor; and
a memory in communication connection with the at least one processor; wherein,
the memory stores instructions executable by the at least one processor, and the instructions, when executed by the at least one processor, enable the at least one processor to implement the filtering method according to any one of claim 1 to 8.

10. A computer readable storage medium having stored thereon a computer program to be executed by a processor, the filtering method according to any one of claim 1 to 8 is implemented when the computer program is executed by the processor.
